# EUROPÄISCHE PATENTSCHRIFT

(11) **EP 0 476 274 B1**
(45) Veröffentlichungstag und Bekanntmachung des Hinweises auf die Patenterteilung: **29.11.1995**
(21) Anmeldenummer: 91112661.3
(22) Anmeldetag: 27.07.1991
(51) Int. Cl.: H05K 13/04, H01R 43/20

(54) **Vorrichtung zur Aufnahme von Objekten und Anwendung der Vorrichtung**
Receiving device of objects and application of the device
Dispositif de réception d'objets et utilisation du dispositif

(30) Priorität: 14.09.1990 CH 2996/90
(43) Veröffentlichungstag der Anmeldung: 25.03.1992
(73) Patentinhaber: SIEMENS-ALBIS AKTIENGESELLSCHAFT, 8047 Zürich (CH); SIEMENS AKTIENGESELLSCHAFT, 80333 München (DE)
(72) Erfinder: Fischer, Bruno, CH-8953 Dietikon (CH)

(56) Entgegenhaltungen:
- EP-A- 0 299 897
- WO-A-90/15518
- GB-A- 2 074 967
- US-A- 4 513 498

## Beschreibung

Die vorliegende Erfindung betrifft eine Vorrichtung gemäss dem Oberbegriff des Patentanspruchs 1 und verschiedene Anwendungen der Vorrichtung.

In verschiedensten Anwendungsgebieten der automatischen Seriefertigung besteht oft das Problem, innerhalb eines Bearbeitungszyklus Gegenstände einer Zuführung zu entnehmen und in bestimmter Anzahl einer anschliessenden Bearbeitungsstation zuzuleiten. Ein typischer Anwendungsfall ist das Bestücken von Komponenten elektrotechnischer Erzeugnisse mit Anschlusselementen, die der Herstellung von elektrischen Verbindungen mit anderen Komponenten dienen. So müssen beispielsweise Leiterplatten oder Steckverbinder mit einer Vielzahl von metallischen Kontaktelementen bestückt werden, die in dafür vorgesehene Öffnungen eingelötet oder eingepresst werden. Die Kontakte werden dabei in der Regel auf Bändern angeliefert, von diesen entnommen und der weiteren Verarbeitung zugeführt. Aus der DE-OS 29 50 460 ist eine Vorrichtung zum Einsetzen von Anschlussstiften in ein Werkstück bekannt, bei der die Anschlussstifte mittels einer Spannvorrichtung einem Trägerstreifen entnommen und einzeln einer Einsetzvorrichtung zugeführt werden. Es kann also nur ein Stift nach dem andern in das Werkstück eingesetzt werden, was gerade bei einer Grossseriefertigung von Steckverbindern und dergleichen wirtschaftlich nicht mehr vertretbare Bearbeitungszeiten zur Folge haben kann. Es ist auch bekannt, einzelne Kontaktreihen von Steckverbindern jeweils in einem Arbeitsgang vollständig zu bestücken, d.h. sämtliche Kon-taktpositionen einer Reihe gleichzeitig mit einem Kontaktelement zu versehen. In vielen Anwendungsfällen werden aber nicht alle Kontaktelemente benötigt, weshalb das Bedürfnis entsteht, bei der Fertigung nur die tatsächlich benutzten Positionen mit einem Kontaktelement zu bestücken, wobei verschiedenste "Muster" von Kontaktbelegungen auftreten können.

In der älteren Patentanmeldung WO 90/155 18 ist eine Vorrichtung - nachstehend "ältere Vorrichtung" genannt - beschrieben, mit der nicht nur mehrere Gegenstände gleichzeitig gefasst, sondern ferner in frei wählbare Abstände zueinander gebracht und anschliessend so der Weiterverarbeitung zugeführt werden können. Diese ältere Vorrichtung erlaubt, eine an sich beliebige Anzahl von Gegenständen gleichzeitig in einen Bearbeitungsablauf einzubeziehen, wobei die Anzahl der Gegenstände und deren Abstände zueinander innerhalb eines vorgegebenen Rasters entsprechend den jeweiligen Gegebenheiten frei wählbar sind. Dabei wird die Rasterauflösung derart gewählt, dass jedes gewünschte Muster bzw. jede gewünschte Anordnung der Gegenstände erzeugt werden kann. Damit wird es in einfacher Weise möglich, z.B. im oben erwähnten konkreten Anwendungsfall die Kontaktreihen bei Steckverbindern nach einem beliebigen Muster zu bestücken, d.h. wahlweise auch beliebige Kontaktpositionen unbestückt zu lassen. Der Einsatz dieser ältere Vorrichtung ermöglicht gerade bei beliebigen Mustern die dem Muster entsprechenden Pakete von Kontaktelementen gleichzeitig bereitzustellen, um sie dann gemeinsam in einer einzigen Operation in die dafür vorgesehenen Öffnungen eines Trägers einzusetzen. Dies gestattet im Vergleich zu anderen Bestückungsverfahren eine erhebliche Verringerung der Bestückungszeit.
Derartige Vorrichtungen sind jedoch mechanisch nicht sehr stark belastbar und verursachen beim Ausfall jeweils grössere Betriebsunterbrüche mit meistens hohen Reparaturkosten. Defekte treten dabei vor allem beim Einschieben oder Einpressen der Objekte in einen Körper auf. So können z.B. in der Vorrichtung verwendete Zangen, die zum Handhaben von Kontaktelementen dienen, beim Einpressen der Kontakte in den Isolierkörper eines Steckverbinders bei den auftretenden hohen Schubkräften verbogen werden. Dadurch wird eine präzise Montage weiterer Kontakte verunmöglicht. Ferner wird die ältere Vorrichtung selbst dann beansprucht, wenn die Gegenstände nur gefasst und wieder abgegeben, nicht aber gegeneinander verschoben werden.

Der vorliegenden Erfindung liegt daher die Aufgabe zugrunde, eine für verschiedenste Einsatzfälle geeignete Vorrichtung der eingangs genannten Art zu schaffen, die mindestens eine eingangs erwähnte ältere Vorrichtung enthält und mit der mehrere Gegenstände gleichzeitig gefasst und in frei wählbare Abstände zueinander gebracht und anschliessend derart der Weiterverarbeitung zugeführt werden können, dass auch beim Auftreten von hohen mechanischen Kräften keine Defekte, insbesondere keine Defekte an teuren Vorrichtungsteilen auftreten. Defekte, die z.B. nach einer Fehlmanipulation trotzdem auftreten, sollen kostengünstig behoben werden können, ohne dass grössere Betriebsunterbrüche eintreten. Ferner soll die Aufnahme und Abgabe von Objekten von verschiedenen Aufnahme- und Abgabeorten möglich sein. Falls die Gegenstände nur gefasst und wieder abgegeben, nicht aber gegeneinander verschoben werden, soll auf die Verwendung der älteren Vorrichtung verzichtet werden können.

Die Lösung dieser Aufgabe gelingt erfindungsgemäss mit einer Vorrichtung, wie sie im Patentanspruch 1 näher gekennzeichnet ist. Vorteilhafte Weiterbildungen und Anwendungen sind in weiteren Ansprüchen angegeben.

Die Vorrichtung erlaubt, eine an sich beliebige Anzahl von Gegenständen gleichzeitig in einen Bearbeitungsablauf einzubeziehen, wobei die Anzahl der Gegenstände und deren Abstände zueinander innerhalb eines vorgegebenen Rasters entsprechend den jeweiligen Gegebenheiten frei wählbar sind. Dabei werden teure Teile der Vorrichtung keinen hohen Belastungen ausgesetzt. Teile der Vorrichtung, die hohen Belastungen ausgesetzt sind, können, falls z.B. nach längerer Betriebszeit trotzdem Defekte auftreten sollten, schnell und unter minimalem Kostenaufwand repariert oder ersetzt werden. Die Vorrichtung ist ferner sehr flexibel, da Gegenstände von verschiedenen Orten zum Teil sogar gleichzeitig aufgenommen und an verschiedenen Orten abgegeben werden können. Falls Gegenstände nur gefasst und wieder abgegeben, nicht aber gegeneinander verschoben werden, entfällt die Verwendung der relativ aufwendigen älteren Vorrichtung. Die mechanische Belastung der älteren Vorrichtung wird dadurch stark reduziert. Zusätzlich sind die Herstellungskosten der erfindungsgemässen Vorrichtung vergleichsweise gering, da mit dem Einsatz einer einzigen älteren Vorrichtung die oben erwähnte Flexibilität erreicht werden kann.

Die Erfindung wird nachfolgend anhand von Zeichnungen beispielsweise näher erläutert.
Es zeigt:
- Fig. 1: eine in der eingangs erwähnten schweiz. Patentanmeldung beschriebene ältere Vorrichtung mit wahlweise verschiebbaren Objektträgern
- Fig. 2: ein Schnittbild der älteren Vorrichtung
- Fig. 3: eine Darstellung zur Funktionsweise der älteren Vorrichtung
- Fig. 4: eine neue Vorrichtung mit Werkzeugen, die sowohl verschiebbare als auch unverschiebbare Objektträger aufweisen
- Fig. 5: eine neue Vorrichtung mit Werkzeugen, die unabhängig voneinander verschiebbar sind

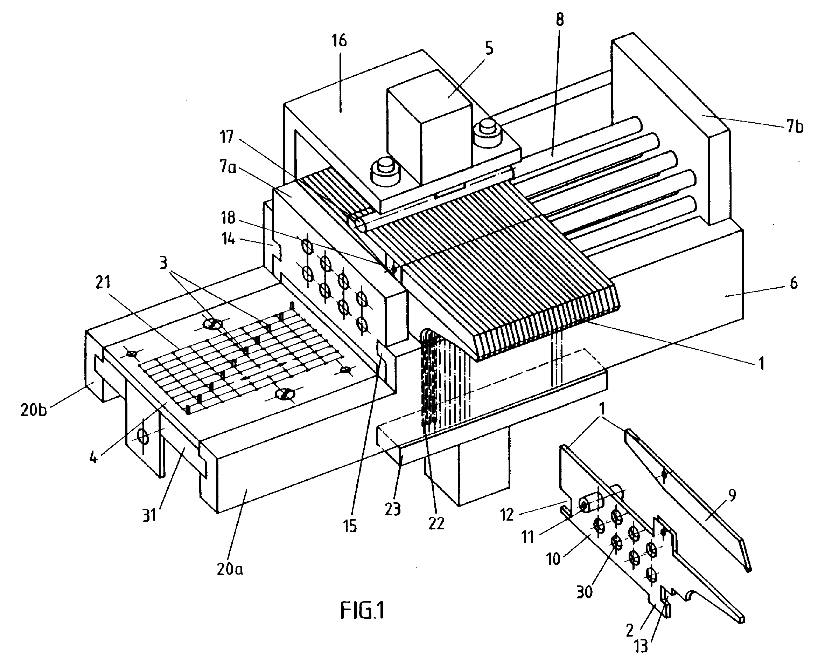

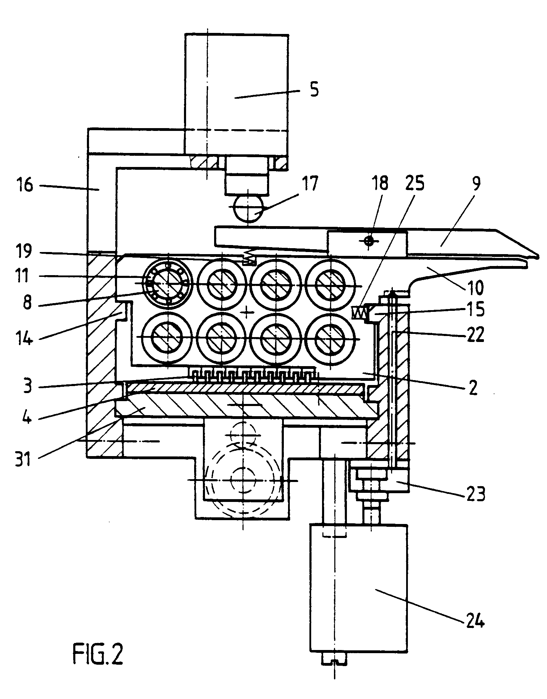

Die Vorrichtung gemäss Fig. 1 und 2 weist auf einem Träger 6 mehrere zwischen zwei Stützen 7a, 7b angeordnete und parallel zueinander verlaufende Führungssäulen 8 auf. Diese dienen je einem unter einer Vielzahl von zwischen den Stützen 7a, 7b verschiebbaren Objektträgern, z.B. Zangen 1, als Führung. Jede Zange 1 weist eine obere und eine untere Spannbacke 9,10 auf. Die untere Spannbacke 10 ist mit einer ein Kugellager aufweisenden Führungshülse 11 versehen, durch die eine der Führungssäulen 8 hindurchführt. Im vorliegenden Beispiel sind die Zangen 1 sehr schmal ausgeführt, weshalb aus Stabilitätsgründen die Führungshülsen 11 beidseitig etwas hervorstehen. Um in diesem Fall trotzdem die einzelnen Zangen 1 möglichst nahe nebeneinander anordnen zu können, sind benachbarte Zangen 1 an unterschiedlichen Führungssäulen 8 geführt. Dabei ragt die Führungshülse 11 einer Zange 1 beidseitig jeweils frei durch entsprechende Bohrungen 30 der benachbarten Zangen 1. Die Dicke der Zangen 1 ist an sich frei wählbar. Die untere Spannbacke 10 weist an ihren beiden längsseitigen Enden zudem je einen Einschnitt 12, 13 auf, die in Führungen 14, 15 des Trägers 6 greifen und beim Verschieben der Zange 1 an diesem entlang gleiten. Eine Druckfeder 25 (Fig.2) zwischen der unteren Spannbacke 10 und der Führung 15 sorgt dafür, dass die Verschiebung der Zangen 1 gleichmässig abläuft. In Fig. 1 sind alle Zangen 1 ohne Zwischenraum nebeneinander in einer Ausgangslage, im folgenden Einsatzbereich genannt, angeordnet.

Alle im Einsatzbereich liegenden Zangen 1 befinden sich unter einer Zangen-Betätigungseinrichtung. Diese besteht im wesentlichen aus einem an einem Halter 16 befestigten pneumatischen Zylinder 5, der mit seinem Kolben auf eine Druckstange 17 wirkt, die bei Betätigung des Zylinders 5 ihrerseits auf die obere Spannbacke 9 aller sich im Einsatzbereich befindlichen Zangen 1 wirkt. Die obere Spannbacke 9 sitzt in einer Halterung der unteren Spannbacke 10 und ist drehbar an einer Welle 18 gelagert. Zwischen dem im geschlossenen Zustand der Zange 1 nicht auf der unteren Spannbacke 10 aufliegenden hinteren Teil der oberen Spannbacke 9 und dem hinteren Teil der unteren Spannbacke 10 ist vertikal eine Druckfeder 19 eingefügt. Beim Öffnen der Zange 1 drückt die Druckstange 17 auf den hinteren Teil der oberen Spannbacke 9 gegen die Druckfeder 19. Sobald die Druckwirkung des Zylinders ausbleibt, nimmt die Zange 1 infolge der Wirkung der Druckfeder 19 selbsttätig wieder den geschlossenen Zustand ein. Die beiden vorderen Enden der Zange 1 sind entsprechend den zu fassenden Gegenständen ausgebildet.

Die untere Spannbacke 10 der Zange 1 ist an ihrer unteren Längsseite mit einer Positioniermarke 2 versehen, die durch einen für alle Zangen 1 unterschiedliche Lange aufweisenden Abschnitt gebildet wird. In Fig. 1 weist die vorderste Zange 1 (erste Zange auf der linken Seite) den kürzesten Abschnitt auf; bei allen nachfolgenden Zangen 1 ist dieser Abschnitt immer um einen bestimmten Betrag länger, d.h. bei der hintersten Zange 1 am längsten. Der Träger 6 der Vorrichtung gemäss Fig. 1 weist ferner zwei Absätze 20a, b mit je einer Führungsnut auf, in die sich ein Schlitten 31 mit einer auswechselbaren plattenförmigen Positioniereinrichtung 4 horizontal einschieben lässt. Der Schlitten 31 ist zusammen mit der Platte 4 unterhalb der Führungssäulen 8 durch nicht weiter dargestellte z. B. pneumatische Mittel in Richtung der Zangen 1 verschiebbar. Auf der Oberseite der Platte 4 sind in einem maschenartigen Raster 21 angeordnete Vertiefungen vorgesehen, in die Positionierstifte 3 einsetzbar sind. Der Rasterabstand ist auf die Abmessungen der unterschiedlichen Positioniermarken 2 der Zangen 1 und auf den Abstand zwischen den Zangen 1 abgestimmt. Beim Einschieben des Schlittens 31 läuft jeder der auf der Platte 4 eingesetzten Positionierstifte 3 auf die entsprechende Positioniermarke 2 auf, worauf die betreffende Zange 1 und die allenfalls unmittelbar dahinterliegenden - in Fig. 1 die rechts davon liegenden - Zangen 1 nach hinten verschoben werden. Die Positionierstifte 3 können innerhalb des vorgegebenen Rasters beliebig gesetzt werden. So kann mit der Positioniereinrichtung 4 in einfacher Weise eine beliebige Anordnung der Zangen 1 zueinander erreicht werden.

Um die Zangen 1 in der gewünschten Anordnung zu fixieren, ist in dem die Führung 15 enthaltenden Teil des Trägers 6 an jeder möglichen Zangenposition innerhalb des Einsatzbereiches ein vertikaler Arretierstift 22 eingesetzt. Alle Stifte 22 sind an ihrem unteren Ende an einem Verbindungselement 23 befestigt, welches mit einer pneumatischen Hebeeinrichtung 24 verbunden und durch diese in vertikaler Richtung verschiebbar ist. Sobald die Zangen 1 die gewünschten Positionen eingenommen haben, wird die Hebeeinrichtung 24 aktiviert und dadurch werden alle sich im Einsatzbereich befindlichen Zangen 1 fixiert.

Selbstverständlich können an Stelle von Zangen 1 auch andere bekannte Objektträger der form-oder kraft - oder reibschlüssigen Art, wie z.B. magnetisch oder mittels Vakuum betriebene Greifelemente eingesetzt werden.

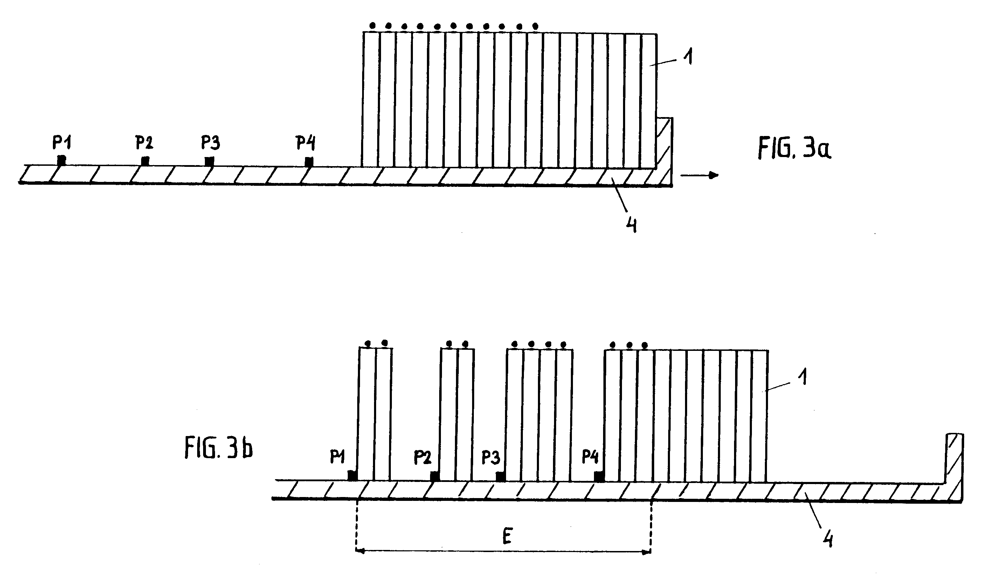

Die Funktionsweise der Vorrichtung soll an einem praxisnahen Beispiel anhand von Fig. 3 verdeutlicht werden, das sich auf eine Anwendung zum Bestücken von Steckverbindern mit Kontaktelementen, d.h. mit Kontaktstiften oder -messern bezieht. Fig. 3a zeigt die Ausgangslage. Die Anzahl der insgesamt zur Verfügung stehenden Zangen 1 betrage 18, welche sich zunächst alle im Einsatzbereich E befinden. Diese Zahl entspricht somit den maximal gleichzeitig bestückbaren Anschlussstiftpositionen. Das Muster für die zu bestückende Kontaktreihe mit 18 Stiftpositionen sehe wie folgt aus: 3 Kontakte - 2 Leerstellen - 4 Kontakte - 2 Leerstellen - 2 Kontakte - 3 Leerstellen - 2 Kontakte. Es sind also insgesamt nur 11 Kontaktelemente einzusetzen und bestimmte dazwischenliegende Positionen freizuhalten. In der Ausgangslage ist die gemäss dem gewünschten Muster mit Positionierstiften P1 ... P4 versehene Platte 4 noch nicht eingeschoben. Durch hier nicht weiter darzustellende Mittel wird die Vorrichtung nun in eine Lage gebracht, in der die ersten 11 Zangen 1 (von links) entsprechend der Anzahl der zu bestückenden 11 Kontaktpositionen auf den die Kontaktelemente anliefernden Träger zugreifen können. Die 11 Zangen 1 entnehmen je ein Kontaktelement und halten es fest. Diese Zangen 1 sind in Fig. 3a mit einem Punkt an ihrem freien Ende gekennzeichnet. Hierauf wird die Positionierplatte 4 in der Vorrichtung nach rechts verschoben. Dadurch werden entsprechend der Anordnung der Positionierstifte P1 ... P4 die Zangen 1 paketweise nach rechts verschoben. Der Positionierstift P4 läuft dabei auf die Positioniermarke der zehnten Zange 1 von rechts auf, wodurch diese mit den neun dahinter liegenden Zangen 1 nach rechts verschoben wird, und zwar bis in eine Stellung, wo die sieben kein Kontaktelement tragenden Zangen 1 ausserhalb des Einsatzbereiches sind. Es bleiben also nur drei Zangen 1 des ersten Paketes im Einsatzbereich, nämlich diejenigen mit den Kontaktelementen. Der Positionierstift P3 läuft während der Verschiebung auf die Positioniermarke der vierzehnten Zange 1 von rechts auf und schiebt diese mit den drei dahinterliegenden Zangen 1 nach rechts. Entsprechendes geschieht mit den Positionierstiften P2 und P1, woraus sich schliesslich die in Fig. 3b dargestellte Anordnung der Zangen 1 ergibt. Diese Anordnung entspricht dem gewünschten Muster der Kontaktanordnung auf dem Steckverbinder.

Alle einen Stift tragenden Zangen 1 befinden sich damit im Einsatzbereich der Vorrichtung. Diese kann nun in eine Lage verbracht werden, in der die Kontaktelemente in den Steckverbinderkörper eingesetzt werden können.

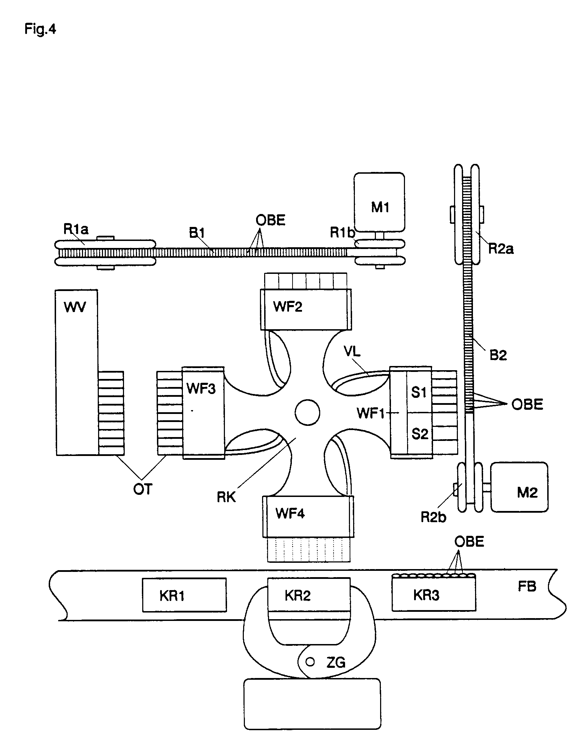

Falls die verschiebbaren Objektträger bzw. Zangen 1 nun z.B. durch eine Vorwärtsbewegung des beschriebenen Bestückungswerkzeugs die Stifte in den Steckverbinderkörper einschieben, treten hohe Kräfte auf. Insbesondere bei ungenauer relativer Positionierung des Werkzeugs zu einem Steckverbinderkörper können beim Einschieben der Stifte Defekte am Bestückungswerkzeug, so z.B. Verbiegungen der Zangen 1 auftreten. Wie erwähnt ist die Reparatur eines derart beschädigten Werkzeugs sehr aufwendig und führt zu einem längeren Betriebsunterbruch, falls kein Austauschwerkzeug vorhanden ist. Diesen Nachteilen kann mit einer Vorrichtung gemäss Fig. 4 begegnet werden.

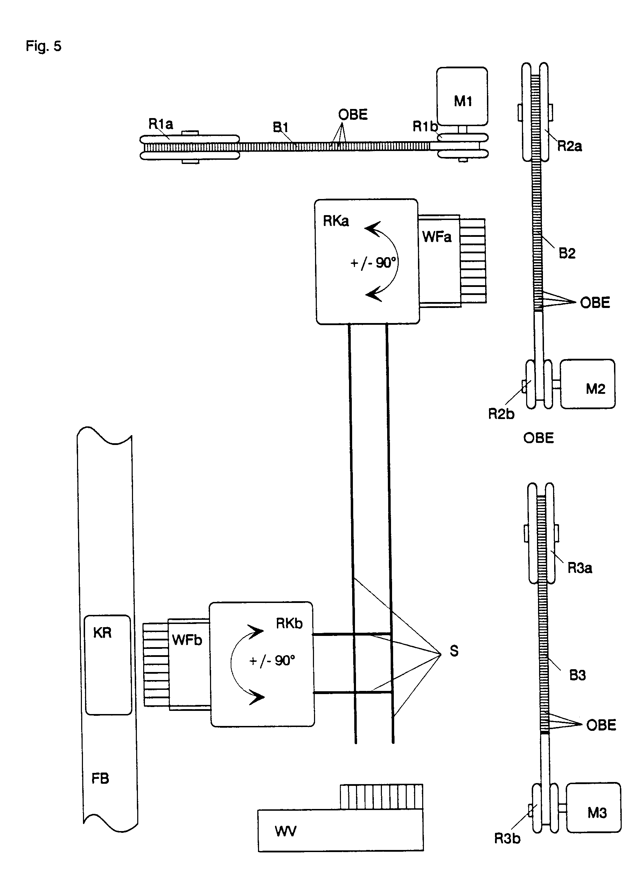

Fig. 4 zeigt eine Vorrichtung mit einem Werkzeug WV, das quer zueinander verschiebbare Objektträger OT aufweist und im Prinzip wie die in Fig. 1 und 2 gezeigte Vorrichtung funktioniert. Ferner sind vier, nicht verschiebbare Objektträger OT aufweisende Werkzeuge WF1,...WF4 auf einem Rotationskörper RK montiert, die Objekte OBE von Bändern B1, B2 oder von einer nicht gezeigten Spendevorrichtung aufnehmen und an auf einem Förderband FB transportierte Körper KR abgeben können. Ferner sind die Werkzeuge WV und WF derart relativ zueinander verschiebbar, dass Objekte OBE zwischen den jeweiligen Objektträgern OT der beiden Werkzeuge WV, WF ausgetauscht werden können. Die Vorrichtung funktioniert wie folgt:
Die Bänder B1, B2 werden mittels einem Schrittmotor M1 bzw. M2 von einer Spule R1a bzw. R2a auf eine Spule R1b bzw. R2b übertragen. Die Objekte OBE, die auf den Bändern B1, B2 z.B. in einem Rasterabstand R1 vorliegen, werden durch Werkzeuge WF, deren Objektträger OT in demselben Rasterabstand R1 angeordnet sind, in vorgegebener Stückzahl aufgenommen und an das Werkzeug WV übergeben oder direkt in Öffnungen von Körpern KR, die einen Rasterabstand R2 aufweisen, eingepresst. Während dem Einpressvorgang werden die Körper KR dabei von einer Festhaltevorrichtung oder Zange ZG positioniert und festgehalten. Objekte OBE, die von einem Werkzeug WF1,...,WF4 aufgenommen und zuerst an das Werkzeug WV übergeben werden, werden durch Verschiebung der Objektträger OT in den gewünschten Rasterabstand zueinander gebracht und anschliessend wieder an eines der Werkzeuge WF1,...,WF4 abgegeben. Falls die Rasterabstände R1, R2 gleich sind, können die Objekte OBE von demselben Werkzeug WF an das Werkzeug WV abgegeben und von diesem wieder aufgenommen werden. Ferner besteht die Möglichkeit, ein weiteres nicht gezeigtes Band derart anzuordnen, dass das Werkzeug WV, z.B. nach einer Drehbewegung, Objekte OBE direkt von diesem Band aufnehmen kann.
Die Montage von z.B. sechs Objekten OBE (z.B. Kontakten) in einem vorbestimmten Muster in einen Körper KR (z.B. in einen Isolierkörper eines Steckverbinders) läuft folgendermassen ab:
Das Band B1 wird vom Schrittmotor M1 um sechs Einheiten vorangetrieben. Sechs Objekte OBE werden vom Werkzeug WF3, dessen Objektträger OT den gleichen oder einen um ein ganzzahliges Vielfaches kleineren Rasterabstand wie die Objekte OBE auf dem Band B1 aufweisen, erfasst und nach einer Drehung des Rotationskörpers RK um 90° an die verschiebbaren Objektträger OT des Werkzeugs WV übergeben. Das Werkzeug WV führt die gewünschte Verschiebung seiner Objektträger OT durch, so dass sich die sechs Objektträger OT mit ihren Objekten OBE nachfolgend in Positionen befinden, die dem erforderlichen Muster entsprechen. Falls der Rasterabstand der Objekttrager OT des Werkzeuges WF3 den gleichen oder einen um ein ganzzahliges Vielfaches kleineren Rasterabstand wie die Öffnungen der Körper KR aufweisen, d.h. falls die Rasterabstände R1, R2 gleich oder um ein ganzzahliges Vielfaches verschieden sind, nimmt das Werkzeug WF3 die Objekte OBE im neu vorliegenden Muster wieder auf und setzt sie nach einer weiteren 90° Drehung des Rotationskörpers RK in die Öffnungen eines Körpers KR ein. Falls die Rasterabstände der Objektträger OT des Werkzeugs WF3 und der Öffnungen des Körpers KR nicht übereinstimmen und die Rasterabstände R1, R2 folglich auch nicht zumindest entsprechend einem ganzzahligen Vielfachen miteinander übereinstimmen, werden die Objekte OBE von einem weiteren Werkzeug WF2, dessen Objektträger OT den geforderten Rasterabstand R2 oder einen um ein ganzzahliges Vielfaches kleineren Rasterabstand aufweisen, vom Werkzeug WV übernommen und eingesetzt. Möglich ist ferner die Verwendung eines Werkzeugs WF1, dessen Objektträger OT in mindestens zwei Bereiche S1, S2 mit verschiedenen Rasterabständen unterteilt sind, die den Rasterabständen R1, R2 der auf den Bändern B1, B2 angeordneten Objekte OBE bzw. der Öffnungen des Körpers KR entsprechen oder je um ein ganzzahliges Vielfaches kleiner sind. Die Objekte OBE würden in diesem Fall z.B. vom Werkzeug WF1 bzw. von den Objektträgern OT des Bereiches S1 dem Band B1 entnommen, dem Werkzeug WV übergeben und dann wieder vom Werkzeug WF1 durch die Objektträger OT des Bereiches S2 abgenommen und in die Öffnungen des Körpers KR eingepresst. Wird bei gleichen Rasterabständen R1, R2 eine volle Bestückung der Körper KR gewünscht, so nimmt z.B. das Werkzeug WF3 Objekte OBE in genügender Stückzahl von einem der Bänder B1, B2 auf und setzt sie ohne zwischenzeitliche Übergabe an das Werkzeug WV direkt in einen Körper KR ein. Da die Objektträger OT der Werkzeuge WF nicht verschiebbar sind, können sie, wie beim Werkzeug WF4 zeichnerisch angedeutet, aus einem Stück gefertigt sein, was zusätzlich ihre mechanische Belastbarkeit erhöht. Das Verschieben und Betreiben der Werkzeuge WF, WV erfolgt dabei z.B. elektrisch oder pneumatisch. Zum Betrieb der Werkzeuge WF auf dem Rotationskörper RK sind Versorgungsleitungen VL vorgesehen. Selbstverständlich können die Werkzeuge WV, WF auch durch vom Rotationskörper RK unabhängige Antriebsvorrichtungen betrieben werden. Nebst den beschriebenen Zuführvorrichtungen mit den Bändern B1, B2 kann auch eine Spendevorrichtung verwendet werden, die eine Anzahl unter Umständen ungeordnet eintreffende Objekte OBE in einen Rasterabstand R1 bringt und in gewünschter Anzahl zur Abnahme durch ein Werkzeug WV oder WF bereitstellt. Ferner kann die Spendevorrichtung auch derart ausgebildet sein, dass eintreffende miteinander verbundene Objekte OBE zuerst vereinzelt und dann zur Abnahme bereitgestellt werden können. Mit der beschriebenen Vorrichtung können daher beliebige Objekte OBE, wie z.B. elektrische oder mechanische Elemente, die an beliebigen Orten in einem beliebigen Raster vorliegen, in einem beliebigen gleichen oder anderen Raster verschiedensten Körpern zugeführt werden, die sich an einer beliebigen Stelle innerhalb des Zugriffsbereichs der Vorrichtung befinden. Wie eingangs erwähnt wird die Rasterauflösung der Werkzeuge WF derart gewählt, dass jedes gewünschte Muster bzw. jede gewünschte Anordnung der Objekte OBE erzeugt werden kann. Selbstverständlich können in der erfindungsgemässen Vorrichtung auch verschiebbare Objektträger OT aufweisende Werkzeuge WV verwendet werden, die anders als die in Fig. 1 gezeigte ältere Vorrichtung aufgebaut sind.
Um die Flexibilität der Vorrichtung noch zu erhöhen, können die Werkzeuge WF auf verschiedenen Dreh-, Schiebe- oder Rotationskörpern angeordnet sein. So kann z.B. das Werkzeug WF, das zur Abgabe der Objekte OBE an die Körper KR vorgesehen ist, auf einem eigenen Rotationskörper RK angeordnet sein. Um die Aufnahme von Objekten OBE von weiteren Bändern zu ermöglichen, kann ein Rotationskörper RKa, der mit einem Werkzeug WFa versehen ist, wie in Fig. 5 gezeigt, auf einer horizontalen Ebene und/oder vertikal verschiebbar und/oder drehbar angeordnet sein. Mit dem Werkzeug WFa können daher Objekte OBE von drei verschiedenen Bändern B1, B2, B3 aufgenommen und an ein Werkzeug WV oder an ein weiteres Werkzeug WFb abgegeben werden. Das Werkzeug WFb, das auf einem weiteren Rotationskörper RKb angeordnet ist, nimmt Objekte OBE vom Werkzeug WV oder direkt vom Werkzeug WFa auf und setzt sie nach einer entsprechenden Drehung des Rotationskörper RKb in einen Körper KR ein, der über ein Förderband FB zugeführt wird. Mit einer derartigen Beweglichkeit der auf Schienen S sich bewegenden Rotationskörper RK können die Werkzeuge WF Objekte OBE natürlich auch an unterschiedlichen Orten wieder abgeben. Insbesondere falls die Objekte OBE durch das Werkzeug WFa nicht nur aufgenommen, sondern auch eingesetzt werden, kann sich der Rotationskörper RKa auch zusammen mit dem Werkzeug WV zwischen den verschiedenen Positionen bewegen. Im letzteren Fall können Zeitverluste durch jeweilige Rückkehr zum Werkzeug WV vermieden werden.

## Patentansprüche

1. Vorrichtung zur Aufnahme von Objekten in einem ersten Raster R1 und zu deren Abgabe in einem zweiten Raster R2, **dadurch gekennzeichnet,** dass mindestens ein Werkzeug (WF) mit gegeneinander unverschiebbaren und mindestens ein Werkzeug (WV) mit gegeneinander verschiebbaren Objektträgern (OT) zum Aufnehmen, Festhalten und wieder Abgeben von Objekten (OBE) vorgesehen sind, dass die Werkzeuge (WV) zur direkten Aufnahme der Objekte (OBE) von zumindest einem Aufnahmeort und/oder zur direkten Übernahme von zumindest einem Werkzeug (WF) ausgebildet sind und dass mindestens ein Werkzeug (WF) zur direkten Aufnahme der Objekte (OBE) von zumindest einem Aufnahmeort und/oder zur direkten Übernahme von zumindest einem Werkzeug (WV) sowie zur Abgabe der Objekte (OBE) an zumindest ein Werkzeug (WV) und/oder an zumindest einen Abgabeort ausgebildet ist.

2. Vorrichtung nach Anspruch 1, **dadurch gekennzeichnet**, dass mindestens eine Zuführvorrichtung vorgesehen ist, die die in einem Rasterabstand R1 vorliegenden Objekte (OBE) zum Aufnahmeort transportiert oder dass eine Spendevorrichtung vorgesehen ist, die die Objekte (OBE) derart handhabt, dass sie vereinzelt in einem Rasterabstand R1 und in gewünschter Anzahl zur Abnahme bereit sind und dass Körper (KR) vorgesehen sind, an die die Objekte (OBE) mit einem Rasterabstand R2 abgegeben werden können.

3. Vorrichtung nach Anspruch 2, **dadurch gekennzeichnet,** dass bei gleichen oder sich um ein ganzzahliges Vielfaches unterscheidenden Rasterabständen R1, R2 die Objektträger (OT) des Werkzeugs (WF) in einem um ein ganzzahliges Vielfaches kleineren oder in einem gleichen Rasterabstand angeordnet sind wie der kleinere der beiden Rasterabstände R1, R2.

4. Vorrichtung nach Anspruch 2, **dadurch gekennzeichnet**, dass bei ungleichen Rasterabständen R1, R2, das Werkzeug (WF) mindestens zwei Bereiche mit Objektträgern (OT) aufweist, die im Rasterabstand R1 bzw. R2 oder in einem um ein Vielfaches kleineren Rasterabstand angeordnet sind oder dass mindestens zwei Werkzeuge (WF) vorgesehen sind, deren Objektträger (OT) im Rasterabstand R1 bzw. R2 oder in einem um ein Vielfaches kleineren Rasterabstand angeordnet sind.

5. Vorrichtung nach Anspruch 1, 2, 3 oder 4, **dadurch gekennzeichnet**, dass die Werkzeuge (WF) zwischen den Aufnahmeorten sowie zwischen mindestens einem der Aufnahmeorte und einem Werkzeug (WV) und ferner zumindest zu einem Abgabeort hin verschiebbar und/oder drehbar angeordnet sind.

6. Vorrichtung nach einem der vorhergehenden Ansprüche , **dadurch gekennzeichnet,** dass die Objektträger (OT) mindestens eines Werkzeuges (WF) eine Einheit bilden.

7. Vorrichtung nach einem der vorhergehenden Ansprüche , **dadurch gekennzeichnet,** dass die mit Objekten (OBE) versehenen Körper (KR) zumindest einer weiteren Vorrichtung, die zur Aufnahme und Abgabe von Objekten dient, zuführbar sind.

8. Vorrichtung nach einem der vorhergehenden Ansprüche , **dadurch gekennzeichnet,** dass die Werkzeuge (WV, WF) auf einem oder mehreren Verschiebe- und/oder Hebe-und/oder Rotationskörpern (RK) angeordnet sind.

9. Anwendung der Vorrichtung nach Anspruch 1 , **dadurch gekennzeichnet,** dass Objekte (OBE), die in einem ersten Raster R1 vorliegen, in ein zweites Raster R2 übergeführt und in einen Körper (KR) eingesetzt werden.

10. Anwendung der Vorrichtung nach Anspruch 1 , **dadurch gekennzeichnet**, dass mechanische oder elektrische Bauelemente (OBE), die in einem ersten Raster R1 vorliegen, in ein zweites Raster R2 übergeführt und in einen Bauelementeträger eingesetzt werden.

11. Anwendung der Vorrichtung nach Anspruch 1 , **dadurch gekennzeichnet**, dass Kontaktelemente, die in einem ersten Raster R1 vorliegen, in ein zweites Raster R2 übergeführt und in einen Isolierkörper eines Steckverbinders eingesetzt bzw. eingepresst werden.

## Claims

1. Arrangement for picking up objects in a first grid R1 and for releasing them in a second grid R2, characterised in that at least one tool (WF) is provided having object carriers (OT), which are not displaceable relative to each other, to pick up, hold fast and re-release objects (OBE), and at least one tool (WV) is provided having object carriers (OT), which are displaceable relative to each other, to pick up, hold fast and re-release objects (OBE), in that the tools (WV) are formed to pick up the objects (OBE) directly from at least one pick-up point and/or to take them over directly from at least one tool (WF) and in that at least one tool (WF) is formed to pick up the objects (OBE) directly from at least one pick-up point and/or to take them over directly from at least one tool (WV) and also to release the objects (OBE) to at least one tool (WV) and/or to at least one release point.

2. Arrangement according to claim 1, characterised in that at least one supply arrangement is provided that transports the objects (OBE), which are present in a grid spacing R1, to the pick-up point or in that a dispensing arrangement is provided that handles the objects (OBE) in such a way that separated in a grid spacing R1 and in a desired number they are ready for removal and in that bodies (KR) are provided, to which bodies the objects (OBE) can be released with a grid spacing R2.

3. Arrangement according to claim 2, characterised in that in the case of grid spacings R1, R2 which are identical or differ by an integral multiple the object carriers (OT) of the tool (WF) are arranged in a grid spacing which is smaller by an integral multiple or in a grid spacing which is identical to the smaller of the two grid spacings R1, R2.

4. Arrangement according to claim 2, characterised in that with non-identical grid spacings R1, R2 the tool (WF) has at least two areas with object carriers (OT) which are arranged in the grid spacing R1 or R2 respectively or in a grid spacing which is smaller by one multiple or in that at least two tools (WF) are provided, the object carriers (OT) of which tools (WF) are arranged in the grid spacing R1 or R2 respectively or in a grid spacing which is smaller by one multiple.

5. Arrangement according to claim 1, 2, 3 or 4,
characterised in that the tools (WF) are arranged such that they can be displaced and/or rotated between the pick-up points and also between at least one of the pick-up points and a tool (WV) and furthermore at least towards one release point.

6. Arrangement according to one of the preceding claims, characterised in that the object carriers (OT) of at least one tool (WF) form a unit.

7. Arrangement according to one of the preceding claims, characterised in that the bodies (KR), which are provided with objects (OBE), can be supplied to at least one further arrangement which is used to pick up and release objects.

8. Arrangement according to one of the preceding claims, characterised in that the tools (WV, WF) are arranged on one or more displacing and/or lifting and/or rotational bodies (RK).

9. Use of the arrangement according to claim 1, characterised in that objects (OBE), which are present in a first grid R1, are transferred into a second grid R2 and inserted into a body (KR).

10. Use of the arrangement according to claim 1, characterised in that mechanical or electrical components (OBE), which are present in a first grid R1, are transferred into a second grid R2 and inserted into a component carrier.

11. Use of the arrangement according to claim 1, characterised in that contact elements, which are present in a first grid R1, are transferred into a second grid R2 and are inserted or pressed into an insulating body of a plug-in connector.

## Revendications

1. Dispositif pour la réception d'objets disposés selon un premier réseau R1 et pour leur délivrance selon un second réseau R2, caractérisé par le fait qu'au moins un outil (WF) possédant des porte-objets (OT) non déplaçables les uns par rapport aux autres, et au moins un outil (WV) possédant des porte-objets (OT) déplaçables les uns par rapport aux autres sont prévus pour recevoir, retenir fermement et à nouveau délivrer des objets (OBE), que les outils (WV) sont agencés pour la réception directe des objets (OBE) à partir d'au moins un emplacement de réception et/ou pour le transfert direct d'au moins un outil (WF), et qu'au moins un outil (WF) pour la réception directe des objets (OBE) à partir d'au moins un emplacement de réception et/ou pour le transfert direct d'au moins un outil (WV) ainsi que pour la délivrance des objets (OBE) est formé sur au moins un outil (WV) et/ou en au moins un emplacement de délivrance.

2. Dispositif suivant la revendication 1, caractérisé par le fait qu'il est prévu au moins un dispositif d'amenée, qui transporte les objets (OBE), qui sont présents avec un pas de réseau R1 jusqu'à l'emplacement de réception, qu'il est prévu un dispositif de distribution qui manipule les objets (OBE) de telle sorte qu'ils sont prêts individuellement en étant individuellement disposés selon un pas de réseau R1 et en étant présents en un nombre désiré pour leur délivrance, et que sont prévus des corps (KR), auxquels les objets (OBE) peuvent être délivrés en étant disposés avec un pas de réseau R2.

3. Dispositif suivant la revendication 2, caractérisé par le fait que dans le cas de pas de réseau R1, R2 identiques ou qui diffèrent d'un multiple entier, les porte-objets (OT) de l'outil (WF) sont disposés avec un pas de réseau identique ou inférieur d'un multiple entier au plus petit des deux pas de réseau R1, R2.

4. Dispositif suivant la revendication 2, caractérisé par le fait que dans le cas de pas de réseau R1, R2 différents, l'outil (WF) comporte au moins trois zones possédant des porte-objets (OT), qui sont disposés en étant répartis avec le pas de réseau R1 ou R2 ou avec un pas de réseau inférieur d'un multiple, ou qu'au moins sont prévus deux outils (WF), dont les porte-objets (OT) sont disposés en étant répartis avec le pas de réseau R1 ou R2 ou avec un pas de réseau inférieur d'un multiple.

5. Dispositif suivant la revendication 1, 2, 3 ou 4, caractérisé par le fait que les outils (WF) sont disposés de manière à être déplaçables et/ou pouvoir tourner entre les emplacements de réception ainsi qu'entre au moins l'un des emplacements de réception et un outil (WV) et en outre au moins en direction d'un emplacement de délivrance.

6. Dispositif suivant l'une des revendications précédentes, caractérisé par le fait que les porte-objets (OT) d'au moins un outil (WF) forment une unité.

7. Dispositif suivant l'une des revendications précédentes, caractérisé par le fait que les corps (KR) équipés d'objets (OBE) peuvent être envoyés au moins à un autre dispositif, qui sert à la réception et à la délivrance d'objets.

8. Dispositif suivant l'une des revendications précédentes, caractérisé par le fait que les outils (WV, WF) sont disposés sur un ou plusieurs corps translatables et/ou corps de levage et/ou corps rotatifs (RK).

9. Utilisation du dispositif suivant la revendication 1, caractérisée par le fait que les objets (OBE), qui sont présents dans un premier réseau R1, sont redisposés selon un second réseau R2 et sont insérés dans un corps (KR).

10. Utilisation du dispositif suivant la revendication 1, caractérisée par le fait que des composants mécaniques ou électriques (OBE), qui sont présents dans un premier réseau R1, sont réarrangés selon un second réseau R2 et sont insérés dans un porte-composants.

11. Utilisation du dispositif suivant la revendication 1, caractérisée par le fait que des éléments de contact, qui sont présents selon un premier réseau R1, sont réarrangés selon un second réseau R2 et sont insérés ou enfoncés dans un corps isolant d'un connecteur.
